# EUROPEAN PATENT SPECIFICATION

(11) **EP 4 238 123 B1**
(45) Date of publication and mention of the grant of the patent: **06.05.2026**
(21) Application number: 21887483.2
(22) Date of filing: 28.10.2021
(51) Int. Cl.: H10H 20/01, H10P 14/24, H10P 14/20, H10P 14/60, H10P 95/00, H01S 5/02, H01S 5/042, H01S 5/183, H01S 5/30, H01S 5/323, H10H 20/82, H10H 20/80

(54) **METHOD OF TRANSFERRING A PATTERN TO AN EPITAXIAL LAYER OF A LIGHT EMITTING DEVICE**
VERFAHREN ZUM ÜBERTRAGEN EINES MUSTERS AUF EINE EPITAKTISCHE SCHICHT EINER LICHTEMITTIERENDEN VORRICHTUNG
PROCÉDÉ DE TRANSFERT D'UN MOTIF SUR UNE COUCHE ÉPITAXIALE D'UN DISPOSITIF ÉLECTROLUMINESCENT

(30) Priority: 28.10.2020 US 202063106444 P
(43) Date of publication of application: 06.09.2023
(73) Proprietor: The Regents of the University of California, Oakland, CA 94607-5200 (US)
(72) Inventor: GANDROTHULA, Srinivas, Koga-shi Ibaraki 306 0041 (JP); KAMIKAWA, Takeshi, Soraku-gun Kyoto, 619--0237 (JP)
(74) Representative: Murgitroyd & Company
(86) International application number: PCT/US2021/056962
(87) International publication number: WO 2022/094018

(56) References cited:
- WO-A1-2020/186205
- WO-A1-2021/081308
- WO-A1-2021/081308
- US-A1- 2020 194 615
- US-A1- 2020 203 228

## Description

### BACKGROUND OF THE INVENTION

### 1. Field of the Invention.

This invention relates to a method of transferring a pattern to an epitaxial layer of a light emitting device.

### 2. Description of the Related Art.

For III-nitride semiconductor devices, such as light emitting diodes (LEDs) and laser diodes (LDs), both extraction and the corresponding output power have been greatly improved by surface roughening methods such as patterned sapphire substrate (PSS) and photoelectrochemical (PEC) etching techniques. In the case of III-nitride LEDs, light extraction efficiency has become the most important limiting factor for the efficiency of the LEDs, since the internal quantum efficiency (IQE) of nitride-based LEDs has been greatly improved (more than 80%) by the availability of low-dislocation GaN substrates and advances in metal organic chemical vapor deposition (MOCVD) techniques.

The effectiveness of these surface roughening methods by and large depends on the crystal orientation and polarity of the to-be-patterned surface. So far, it has only been established for the nitrogen-face of a c-polar [0001] GaN and has not yet been available for arbitrary GaN crystal orientations and polarity, including most semipolar surfaces and nonpolar a-plane and m-plane surfaces.

Reactive ion etching (RIE) is another method used to pattern conical features to enhance light extraction irrespective of crystal orientation. On the other hand, a limitation lies in the non-controllability of the direction of emitted light.

Improving the directionality of light emission has been widely studied either through the use of microcavities or photonic crystals (PhCs) to control the propagation of electromagnetic modes in optoelectronic devices. The periodic modulation of refraction serves as an optical grating to couple guided modes from the semiconductor device to air, thus increasing extraction efficiency and directionality of LEDs. The application of gratings for the light diffraction in optoelectronic devices requires the grating period to be on the order of half of the wavelengths of the light generated by the device. In the case of GaN based optoelectronic devices, the grating period needs to be on the order of a few hundreds of nanometers.

The main difficulty of PhC LEDs is their delicate required fabrication. Thus, there is a need in the art for improved methods of fabricating light guiding or extracting features.

### SUMMARY OF THE INVENTION

To overcome the limitations in the prior art described above, and to overcome other limitations that will become apparent upon reading and understanding this specification, the present invention discloses a method according to claim 1 wherein one or more light-emitting devices fabricated on a wing of III-nitride epitaxial lateral overgrowth (ELO) layers, thereby resulting in a device that has good crystal quality in terms of reduced dislocation densities and stacking faults.

Specifically, this invention performs the following steps: island-like III-nitride semiconductor layers are grown on a substrate using a growth restrict mask and the ELO method, where the growth restrict mask plays an important role for obtaining a desired light extraction or light guiding function. Before the growth, the growth restrict mask is patterned with one or more random valley-hill patterns.

Thereafter, devices are fabricated on the wings of the III-nitride ELO layers, and the devices are plucked from the host substrate. Note that isolated devices may remain on the host substrate with a very minimal link, such as an epitaxial or non-epitaxial bridge, until the whole device is finished. Once removed from the substrate, the devices may be transferred to another carrier or substrate by an elastomer stamp, vacuum chuck, adhesive tape, or simply by bonding or attaching the devices to the separate carrier or substrate.

The III-nitride semiconductor layers are dimensioned such that one or more of the island-like III-nitride semiconductor layers form a bar (known as a bar of a device). By doing this, nearly identical devices can be fabricated adjacent to each other in a self-assembled array, and thus, by integration, scale up can be made easier.
Alternatively, the III-nitride ELO layers can be made to coalesce initially, such that they can be later divided into bars of devices or individual devices.

Every device can be addressed separately or together with other devices, by designing a proper fabrication process. For example, one could make a common cathode or anode for such a bar of devices for monolithic integration, or one can address individual devices for full color display applications. Consequently, a high yield can be obtained.

Key aspects of this invention include:
- Light extraction and/or directionality are controlled.
- Light extraction or guiding features are introduced on wings of the III-nitride ELO layers, before growth of active layers of the device.
- Light extraction or guiding features are placed on a backside of the III-nitride ELO layers.
- Roughing or periodic patterning is carried out without a chemical etchant or plasma damage of dry etching process.
- Roughing or periodic patterning is made on epitaxial layers.
- Roughing or periodic patterning are near the active region.
- The light emitting area of the device is fabricated on wings of the III-nitride ELO layers, thereby providing better crystal quality in the light emitting area, which improves performance.
- This invention can be utilized to increase yield by making smaller footprint devices confined to the wings of the III-nitride ELO layers.
- This invention can utilize foreign substrates, such as Si, SiC, sapphire, template substrates, ELO assisted semiconducting substrates, etc., to scale up manufacturability for industrial needs.
- This invention is independent of crystal orientations of the host substrate.
- The substrate can be recycled for a next batch of devices.

A few of the possible designs using this method are illustrated in the following detailed description of the invention.

### BRIEF DESCRIPTION OF THE DRAWINGS

Referring now to the drawings in which like reference numbers represent corresponding parts throughout:
Figs. 1A, 1B and 1C are schematics of a substrate, growth restrict mask and coalesced and non-coalesced epitaxial layers, according to one embodiment of the present invention.
Fig. 2 is a flow chart for a method of fabricating light emitting devices.
Figs. 3A, 3B and 3C are schematics of a growth restrict mask with different shapes of possible patterns.
Figs. 4A, 4B and 4C illustrate experimental results for various patterns of a host substrate and growth restrict mask.
Figs. 5A, 5B, 5C and 5D illustrate structures for realizing a plano-concave resonant cavity VCSEL.
Figs. 6A, 6B and 6C illustrate different types of curved shapes obtained at an interface of epitaxial lateral overgrowth layer.
Figs. 7A and 7B illustrate devices fabricated using the present invention.

### DETAILED DESCRIPTION OF THE INVENTION

In the following description of the preferred embodiment, reference is made to a specific embodiment in which the invention may be practiced. It is to be understood that other embodiments may be utilized, and structural changes may be made without departing from the scope of the present invention.

### Overview

The present invention describes a method of fabricating semiconductor devices, such as light emitting devices, including LEDs and plano-concave VCSELs, by designing a growth restrict mask accordingly. As ELO is relied on in this invention, this invention is easily applicable to foreign substrates, such as Si, SiC, sapphire, templates of semiconductor layers, or a host substrate containing ELO engineered layer templates. ELO engineered layer templates make it possible to use GaN on sapphire substrates, GaN on silicon substrates, etc. LEDs, PhC LEDs and VCSELs can be fabricated on good crystal quality ELO wings, and then the respective devices can be isolated from the host substrate, to be picked selectively, or to be transferred onto a display back panel or to a product.

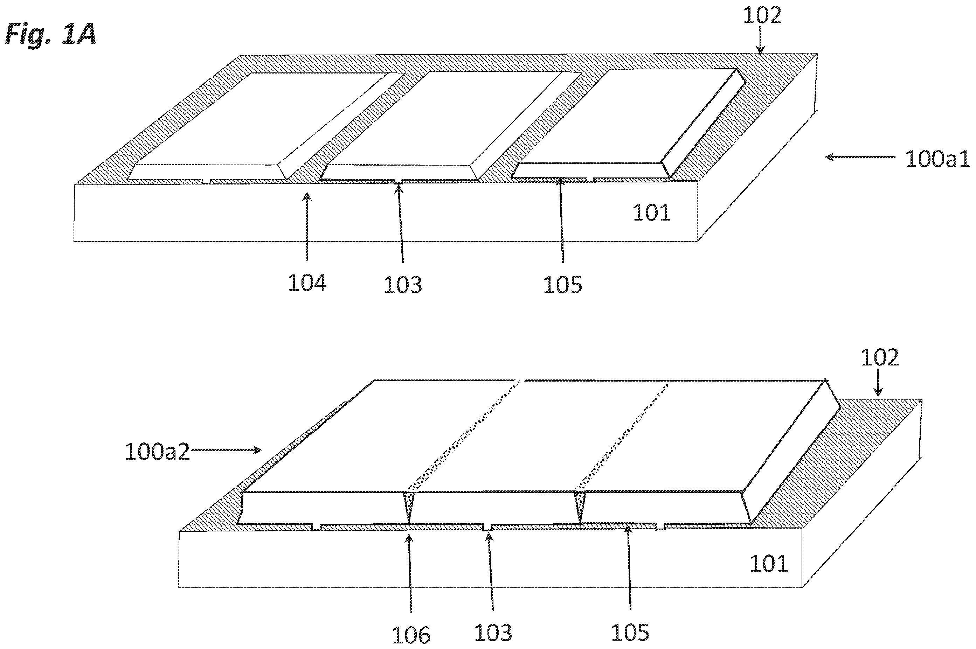

Fig. 1A illustrates a method using schematics 100a1 and 100a2. The method first provides a III-nitride-based substrate 101, such as a bulk GaN substrate 101.

Schematic 100a1 shows a growth restrict mask 102 is formed on or above the III-nitride based substrate 101. Specifically, the growth restrict mask 102 is disposed directly in contact with the substrate 101, or is disposed indirectly through an intermediate layer grown by MOCVD, etc., made of a III-nitride-based semiconductor layer or template deposited on the substrate 101.

The growth restrict mask 102 can be formed from an insulator film, for example, an SiO₂ film deposited upon the base substrate 101, for example, by a plasma chemical vapor deposition (CVD), sputter, ion beam deposition (IBD), etc., wherein the SiO₂ film is patterned by photolithography using a predetermined photo mask and then etched to include opening areas 103, as well as no-growth regions 104 (which may or may not be patterned). The present invention can use SiO₂, SiN, SiON, TiN, etc., as the growth restrict mask 102. A multi-layer growth restrict mask 102 which is comprised of the above materials is preferred.

Epitaxial III-nitride layers 105, such as GaN-based layers, are grown using the ELO method on the GaN substrate 101 and the growth restrict mask 102. The growth of the III-nitride ELO layers 105 occurs first in the opening areas 103 on the III-nitride based substrate 101, and then laterally from the opening areas 103 over the growth restrict mask 102. The growth of the III-nitride ELO layers 105 may be stopped or interrupted before the III-nitride ELO layers 105 at adjacent opening areas 103 can coalesce on top of the growth restrict mask 102, wherein this interrupted growth results in the no-growth regions 104 between adjacent III-nitride ELO layers 105. Alternatively, the growth of the III-nitride ELO layers 105 may be continued and coalesce with neighboring III-nitride ELO layers 105, as shown in schematic 100a2, thereby forming a coalesced region 106 of increased defects at a meeting region.

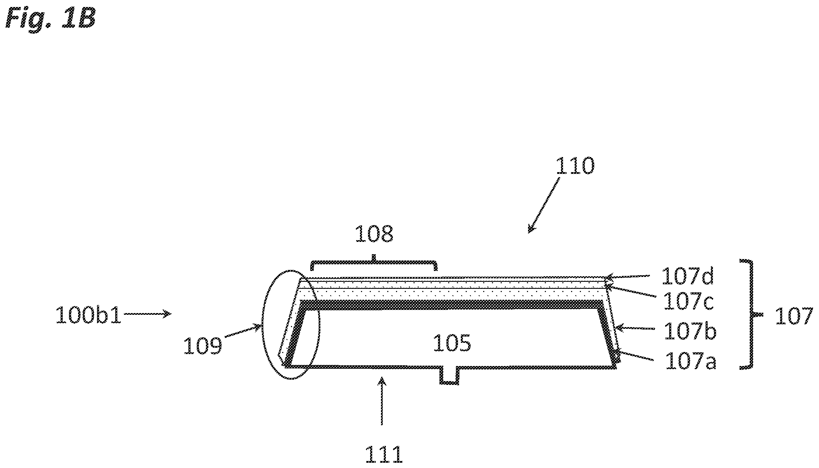

In Fig. 1B, schematic 100b1 illustrates how additional III-nitride device layers 107 may include an active region 107a, p-type layer 107b, electron blocking layer (EBL) 107c, and cladding layer 107d, as well as other layers. These additional III-nitride device layers 107 are deposited on or above the III-nitride ELO layers 105.

The III-nitride ELO layers 105 and III-nitride device layers 107 include one or more flat surface regions 108 and layer bending regions 109 at the edges thereof adjacent the no-growth regions 104, when the III-nitride ELO layers 105 stopped before coalescing as shown in 100a1 of Fig. 1A, or when the III-nitride ELO layers 105 continued to coalesce in a coalesced region 106 as shown in 100a2 of Fig. 1A. The width of the flat surface region 108 is at least 3 µm, and most preferably is 10 µm or more.

A light-emitting active region 107a of a device 110 is processed at the flat surface regions 108, preferably between opening area 103 and the edge portion 109 or coalesced region 106. By doing so, a bar of a device 110 will possess an array of twin or nearly identical light emitting apertures on either side of the opening area 103 along the length of the bar. Moreover, electrodes may be placed on the device layers 107, as well as a backside interface 111 between the III-nitride ELO layers 105 and the growth restrict mask 102.

There are many methods of removing the light emitting devices 110 from the substrate 101. For example, the present invention can utilize the ELO method for removing the light emitting devices 110. In the present invention, the bonding strength between the substrate 101 and the III-nitride ELO layers 105 is weakened by the growth restrict mask 102. In this case, the bonding area between the substrate 101 and the III-nitride ELO layers 105 is the opening area 103, wherein the width of the opening area 103 is narrower than the III-nitride ELO layers 105. Consequently, the bonding area is reduced by the growth restrict mask 102, so that this method is preferable for removing the epitaxial layers 105, 107.

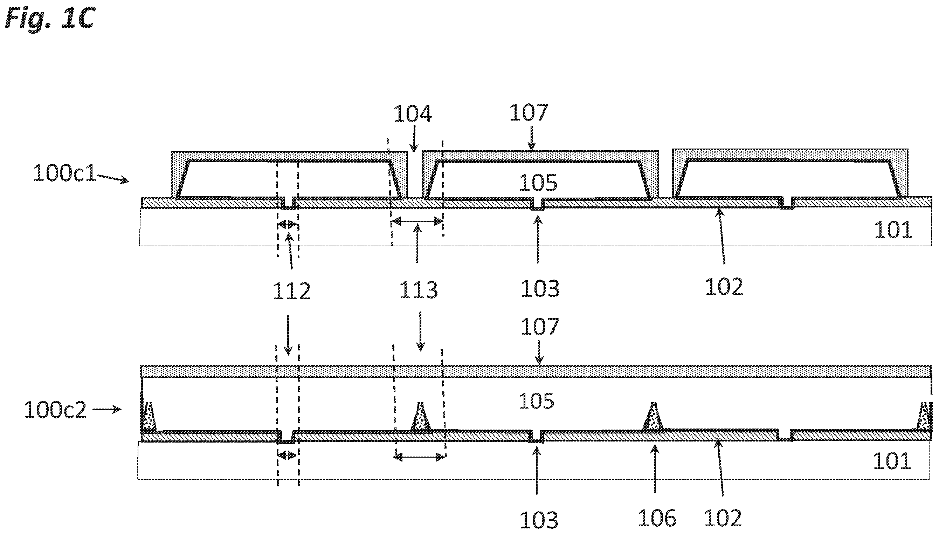

In schematics 100c1 and 100c2 in Fig. 1C, an open region of the III-nitride ELO layers 105 is labeled as region 112 and a region at the which wings of the neighboring III-nitride ELO layers 105 may or may not meet is labeled as region 113.

This invention proposes several approaches in order to realize a light extraction or light guiding tools for the light emitting devices.

The typical fabrication steps for this invention are described in more detail below:
Step 1: Forming a desired shape on the growth restrict mask 102, which can be achieved by the following. The growth restrict mask 102 is placed on the host substrate 101, wherein the growth restrict mask 102 is patterned or shaped either using nano-imprint lithography, or the pattern or shape can be transferred onto the growth restrict mask 102 using photolithography and wet etching, or photolithography and dry etching.
Step 2: The growth restrict mask 102 has a plurality of striped opening areas 103 exposing the substrate 101, wherein the substrate 101 is a III-nitride-based semiconductor, or the substrate 101 is a hetero-substrate (silicon, silicon nitride, sapphire, etc.), or a template is prepared including the growth restrict mask 102.
Step 3: A plurality of epitaxial layers 105, 107 are grown on or above the substrate 101 using the growth restrict mask 102, such that the growth extends in a direction parallel to the striped opening areas 103 of the growth restrict mask 102. The epitaxial layers 105, 107 take the pattern or shape designed on the growth restrict mask 102, such that the designed pattern or shape is transferred onto the interface 111 surface between the III-nitride ELO layers 105 and the growth restrict mask 102.
Step 4: A light emitting device 110 such as an LED or a VCSEL is fabricated on a wing region of the III-nitride ELO layers 105, mostly on the flat surface region 108, by conventional methods.
Step 5: Divide the devices 110 and isolate the devices 110 on the host substrate 101.
Step 6: Attach a sub-mount.
Step 7: Dissolve the growth restrict mask 102 and protection layers using a chemical etchant like buffered hydrofluoric acid (BHF) or hydrofluoric acid (HF).
Step 8: Separate the devices 110 from the host substrate 101.
Step 9: Perform final processing of the devices 110, such as placing distributed Bragg reflectors (DBRs) on the curved mirror for VCSELs, and then package the devices 110.

### Process Steps

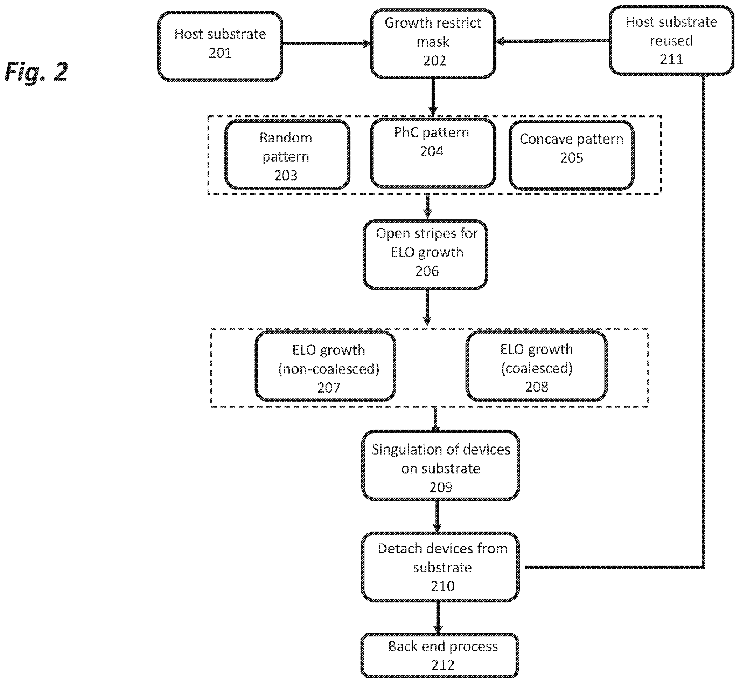

Fig. 2 is a flowchart illustrating the steps for device 110 realization, according to an embodiment of the present invention.

Block 201 represents the step of providing a host substrate 101, wherein the host substrate 101 is a semiconducting substrate, and the semiconducting substrate is independent of crystal orientation. In one example, the host substrate 101 has one or more trenches.

Block 202 represents the step of forming a growth restrict mask 102 on the host substrate 101, wherein the growth restrict mask is comprised of one or more layers.

Blocks 203, 204 and 205 represent the steps of forming one or more patterns on the growth restrict mask 102 and/or the host substrate 101, wherein the patterns result in light controlling structures at an interface between the III-nitride ELO layers 105 and the host substrate 101. Specifically, Block 203 comprises one or more random patterns, such as one or more random valley-hill patterns, for example, one or more unleveled regions; Block 204 represents a 2D periodic lattice array equal in size to a wavelength of light emitted from an active region 107a, namely, a PhC; and Block 205 represents one or more concave patterns or curved surfaces, for example, a plano-concave mirror of a resonant cavity of a vertical cavity surface emitting laser (VCSEL). wherein the resonant cavity is comprised of one or more layers grown epitaxially.

Block 206 represents the step of opening stripes comprised of opening areas 103 on the growth restrict mask 102 for ELO growth.

Blocks 207, 208 represent the steps of growing the III-nitride ELO layers 105 on the growth restrict mask 102, wherein the III-nitride ELO layers 105 may be non-coalesced in Block 207 or coalesced in Block 208, followed growing the III-nitride device layers 107 on the III-nitride ELO layers 105.

Block 209 represents the step of singulating the devices 110 on the host substrate 101.

Block 210 represents the step of detaching the devices 110 from the host substrate 101, and Block 211 represents the step of reusing the host substrate 101.

Block 212 represents the step of performing any necessary back-end processing of the devices 110, e.g., for VCSEL devices 110.

These steps are described in more detail below.

### Forming a growth restrict mask

In one embodiment, the III-nitride layers 105 are grown by ELO on a III-nitride substrate 101, such as an m-plane GaN substrate 101 patterned with a growth restrict mask 102 comprised of SiO₂, wherein the III-nitride ELO layers 105 may or may not coalesce on top of the SiO₂.

The growth restrict mask 102 is comprised of striped opening areas 103, wherein the SiO₂ stripes of the growth restrict mask 102 between the opening areas 103 have a width of 1 µm-20 µm and an interval of 10 µm-100 µm. if a nonpolar substrate used the opening areas 103 are oriented along a <0001> axis. If semipolar (20-21) or (20-2-1) planes are used, the opening areas 103 are oriented in a direction parallel to [-1014] or [10-14], respectively. Other planes may be use as well, with the opening areas 103 oriented in other directions.

When using a III-nitride substrate 101, the present invention can obtain high quality III-nitride semiconductor layers 105, 107. As a result, the present invention can also easily obtain devices with reduced defect density, such as dislocation and stacking faults.

Moreover, these techniques can be used with a hetero-substrate, such as sapphire, SiC, LiAlO₂, Si, Ga₂O₃ etc., as long as it enables growth of the III-nitride ELO layers 105 through the growth restrict mask 102.

### Pattern on growth restrict mask

Before proceeding to opening of stripes on growth restrict mask 102, a pre-process is carried on the growth restrict mask 102. This invention proposes three different possible types of patterns for the devices 110; however, several alternative designs may also be practiced in the same way as described below. A random-hill-valley pattern on the growth restrict mask 102 will translate onto the interface 111 with the ELO layers 105 during the MOCVD growth. Device 110 fabrication, including p-pads and n-pad, is carried on the surface of the III-nitride ELO layers 105, devices 110 are singularized on the host substrate 101, and the devices 110 are picked using a carrier wafer. The result leaves the random-hill-valley pattern at the interface 111 of the III-nitride ELO layers 105. In the case of PhCs for LEDs, the patterns must have dimensions on the order of the wavelength of the light emitted by the device 110; in the case of PhCs for VCSELs, a concave surface with a radius of curvature designed such that a beam waist must pass through the plano-concave mirror cavity with less losses.

### Growing epitaxial layers on the substrate using the growth restrict mask

The III-nitride semiconductor device layers 107 are grown on the III-nitride ELO layers 105 in the flat region 108 by conventional methods. In one embodiment, MOCVD is used for the epitaxial growth of the island-like III-nitride semiconductor layers including the III-nitride ELO layers 105 and the III-nitride semiconductor device layers 107. The island-like III-nitride semiconductor layers 105, 107 are separated from each other, because the MOCVD growth is stopped before the III-nitride ELO layers 105 coalesce. In one embodiment, the island-like III-nitride semiconductor layers 105, 107 are made to coalesce and later etching is performed to remove unwanted regions.

Trimethylgallium (TMGa), trimethylindium (TMIn) and triethylaluminium (TMAl) are used as III elements sources. Ammonia (NH₃) is used as the raw gas to supply nitrogen. Hydrogen (H₂) and nitrogen (N₂) are used as a carrier gas of the III elements sources. It is important to include hydrogen in the carrier gas to obtain a smooth surface epi-layer.

Silane and Bis(cyclopentadienyl)magnesium (Cp₂Mg) are used as n-type and p-type dopants. The pressure setting typically is 67 to 1013 hPa (50 to 760 Torr). III-nitride-based semiconductor layers are generally grown at temperature ranges from 700 to 1250 °C.

For example, the growth parameters include the following: TMG is 12 sccm, NH₃ is 8 slm, carrier gas is 3 slm, SiH₄ is 1.0 sccm, and the V/III ratio is about 7700.

### ELO of Limited Area Epitaxy (LAE) III-nitride layers

In the prior art, a number of pyramidal hillocks have been observed on the surface of m-plane III-nitride films following growth. See, for example, US Patent Application Publication No. 2017/0092810. Furthermore, a wavy surface and depressed portions have appeared on the growth surface, which made the surface roughness worse. This is a very severe problem. For example, according to some papers, a smooth surface can be obtained by controlling an off-angle (>1 degree) of the substrate's growth surface, as well as by using an N₂ carrier gas condition. These are very limiting conditions for mass production, however, because of the high production costs. Moreover, GaN substrates have a large fluctuation of off-angles to the origin from their fabrication methods. For example, if the substrate has a large in-plane distribution of off-angles, it has a different surface morphology at these points in the wafer. In this case, the yield is reduced by the large in-plane distribution of the off-angles. Therefore, it is necessary that the technique does not depend on the off-angle in-plane distribution.

The present invention solves these problems as set forth below:
1. The growth area is limited by the area of the growth restrict mask 102 from the edges of the substrate 101.
2. The substrate 101 is a nonpolar or semipolar III-nitride substrate 101 that has off-angle orientations ranging from -16 degrees to +30 degrees from the m-plane towards the c-plane, and c-plane. Alternatively, a hetero-substrate 101 with a III-nitride-based semiconductor layer deposited thereon may be used, wherein the layer has an off-angle orientation ranging from +16 degrees to -30 degrees from the m-plane towards the c-plane.
3. The island-like III-nitride semiconductor layers 105, 107 have a long side that is perpendicular to an a-axis of the III-nitride-based semiconductor crystal.
4. During MOCVD growth, a hydrogen atmosphere can be used.

In this invention, a hydrogen atmosphere can be used during non-polar and semi-polar growth. Using this condition is preferable because hydrogen can prevent excessive growth at an edge of the open area 103 from occurring in the initial growth phase.

Those results have been obtained by the following growth conditions.

In one embodiment, the growth pressure ranges from 80 to 1013 hPa (60 to 760 Torr). although the growth pressure preferably ranges from 133 to 400 hPa (100 to 300 Torr) to obtain a wide width for the island-like III-nitride semiconductor layers 105, 107; the growth temperature ranges from 900 to 1200 °C degrees; the V/III ratio ranges from 10 - 30,000; the TMG is from 2 - 20 sccm; NH₃ ranges from 0.1 to 10 slm; and the carrier gas is only hydrogen gas, or both hydrogen and nitrogen gases. To obtain a smooth surface, the growth conditions of each plane needs to be optimized by conventional methods.

After growing for about 2 - 8 hours, the III-nitride ELO layers 105 had a thickness of about 1 - 50 µm and a bar width of about 50 - 150 µm.

### Fabricating the device

The device 110 is fabricated at the flat surface region 108 by conventional methods, wherein various device 110 designs are possible. For example, for µLEDs, if only a front-end process is necessary to realize the device 110, p-pads and n-pads can be fabricated either along the length or width of the wing of the III-nitride ELO layers 105.

### Forming a structure for separating device units

The aim of this step is to isolate devices 110 from the host substrate 101 for the III-nitride ELO layers 105 and III-nitride device layers 107. At least two methods can be used to transfer the devices 110 onto a carrier substrate.

In one method, the III-nitride ELO layers 105 and device layers 107 are separated from the host substrate 101 by etching regions 112, 113 at least to expose the growth restrict mask 102. The separating may also be performed via scribing by a diamond tipped scriber or laser scriber, for example, tools such as RIE (Reactive Ion Etching) or ICP (Inductively Coupled Plasma); but is not limited to those methods also be used to isolate devices 110.

To keep the isolated III-nitride device layers 107 on the host substrate 101, region 112, which connects the III-nitride ELO layers 105 directly with the host substrate 101, was modified in such a way that a connecting link with the host substrate 101 still remains even after exposing the growth restrict mask 102 at region 113. Alternatively, one may choose to eliminate any connection with the host substrate 101 at the open area 103 by etching all the open area 103.

In another method, devices 110 are isolated by etching at region 113 to at least expose the growth restrict mask 102 (in the case of ELO Type 2). Then, the method described in the publication by Srinivas Gandrothula et al, Appl. Phys. Express, vol. 13, p. 041003 (2020), can be used to isolate devices 110 from the host substrate 101. Alternatively, one may also use a supporting carrier, such as a sub-mount, before attaching an adhesive film to transfer isolated devices 110 onto the carrier.

### ELO III-nitride device layers are removed from the substrate

After etching regions 112 and 113, whichever is best, the completed III-nitride device layers 107 may be transferred from their host substrate 101 using one of the following methods.

When a substrate 101 is left with a weak connecting link or no link after etching regions 112, 113:
1. Elastomer stamps (PDMS stamps): PDMS stamps are flexible enough to pick the isolated III-nitride device layers 107 from the host substrate 101. One may also pick device layers 107 selectively in order to transfer them on to a target back panel.
2. Vacuum chuck: Anew way to pick isolated III-nitride device layers 107 from the host substrate 101, when the III-nitride device layers 107 have a weak connecting link to the host substrate 101, is to use a vacuum controlled chuck to remove the III-nitride device layers 107.

When etching is not performed at region 112:
1. After isolating the devices 110 while region 112 is untouched, an adhesive film is placed over the devices 110 and, using the assistance of low temperature and slight pressure, the devices 110 are peeled off the host substrate 101.
2. Alternatively, a supporting carrier may also be used along with an adhesive film, and following a similar procedure to peel the devices 110, so that the devices 110 can be transferred onto a stiff carrier substrate.

### Mounting the device on a display panel

The divided/isolated devices 110 are lifted using the approaches described above: (1) a PDMS stamp; or (2) vacuum chuck.

### Using a vacuum chuck to pick the device

This invention provides a solution to the problem of mass transferring devices 110 with smaller light emitting apertures, also called emissive inorganic pixels, when targeted sizes are below 50 µm. These devices 110, known as µLEDs, are fabricated on the wings of the III-nitride ELO layers 105, and can be removed from the substrate 1010 as mentioned above. In particular, these devices 110 preferably have larger wing regions of the III-nitride ELO layers 105 and smaller open regions 112, that is, a ratio between the wing region and open region 112 should be more than 1, more preferably 5-10, and in particular, open regions 112 should be around 1-5 µm. Therefore, devices 110 can be removed from the III-nitride substrate 101 more easily, and can be transferred to external carriers or processed in further steps in an easy manner.

### Definitions of Terms

### III-nitride-based substrate

The III-nitride-based substrate 101 may comprise any type of III-nitride-based substrate, as long as a III-nitride-based substrate enables growth of III-nitride-based semiconductor layers 105, 107 through a growth restrict mask 102, any GaN substrate 101 that is sliced on a {0001}, {11-22}, {1-100}, {20-21}, {20-2-1}, {10-11}, {10-1-1} plane, etc., or other plane, from a bulk GaN, and AlN crystal substrate.

### Hetero-substrate

Moreover, the present invention can also use a hetero-substrate 101. For example, a GaN template or other III-nitride-based semiconductor layer may be grown on a hetero-substrate 101, such as sapphire, Si, GaAs, SiC, Ga₂O₃, etc., prior to the growth restrict mask 102. The GaN template or other III-nitride-based semiconductor layer is typically grown on the hetero-substrate 101 to a thickness of about 2 - 6 µm, and then the growth restrict mask 102 is disposed on the GaN template or another III-nitride-based semiconductor layer.

### Growth restrict mask

The growth restrict mask 102 comprises a dielectric layer, such as SiO₂, SiN, SiON, Al₂O₃, AIN, AlON, MgF, ZrO₂, TiN, etc., or a refractory metal or precious metal, such as W, Mo, Ta, Nb, Rh, Ir, Ru, Os, Pt, etc. The growth restrict mask 102 may be a laminate structure selected from the above materials. It may also be a multiple-stacking layer structure chosen from the above materials.

In one embodiment, the thickness of the growth restrict mask 102 is about 0.05 - 3 µm. The width of the mask 102 is preferably larger than 20 µm, and more preferably, the width is larger than 40 µm. The growth restrict mask 102 is deposited by sputter, electron beam evaporation, plasma-enhanced chemical vaper deposition (PECVD), ion beam deposition (IBD), etc., but is not limited to those methods.

On an m-plane free standing GaN substrate 101, the growth restrict mask 102 comprises a plurality of opening areas 103, which are arranged in a first direction parallel to the 11-20 direction of the substrate 101 and a second direction parallel to the 0001 direction of the substrate 101, periodically at intervals extending in the second direction. The length of the opening area 103 is, for example, 200 to 35000 µm; the width is, for example, 2 to 180 µm; and the interval of the opening area 103 is, for example, 20 to 180 µm. The width of the opening area 103 is typically constant in the second direction but may be changed in the second direction as necessary.

On a c-plane free standing GaN substrate 101, the opening areas 103 are arranged in a first direction parallel to the 11-20 direction of the substrate 101 and a second direction parallel to the 1-100 direction of the substrate 101.

On a semipolar (20-21) or (20-2-1) GaN substrate 101, the opening areas 103 are arranged in a direction parallel to [-1014] and [10-14], respectively.

Alternatively, a hetero-substrate 101 can be used. When a c-plane GaN template is grown on a c-plane sapphire substrate 101, the opening area 103 is in the same direction as the c-plane free-standing GaN substrate 101; when an m-plane GaN template is grown on an m-plane sapphire substrate 101, the opening area 103 is same direction as the m-plane free-standing GaN substrate 101. By doing this, an m-plane cleaving plane can be used for dividing the bar of the device 110 with the c-plane GaN template, and a c-plane cleaving plane can be used for dividing the bar of the device 110 with the m-plane GaN template; which is much preferable.

### III-nitride-based semiconductor layers

The III-nitride ELO layers 105 and the III-nitride semiconductor device layers 107 can include In, Al and/or B, as well as other impurities, such as Mg, Si, Zn, O, C, H, etc.

The III-nitride-based semiconductor device layers 107 generally comprise more than two layers, including at least one layer among an n-type layer, an undoped layer and a p-type layer. The III-nitride-based semiconductor device layers 107 specifically comprise a GaN layer, an AlGaN layer, an AlGaInN layer, an InGaN layer, etc. In the case where the device 110 has a plurality of III-nitride-based semiconductor layers 105, 107, the distance between the island-like III-nitride semiconductor layers 105, 107 adjacent to each other is generally 30 µm or less, and preferably 10 µm or less, but is not limited to these figures. In the semiconductor device 110, a number of electrodes according to the types of the semiconductor device 110 are disposed at predetermined positions.

### Flat surface region

The flat surface region 108 is between layer bending regions 109. Furthermore, the flat surface region 108 is in the region of the growth restrict mask 102.

Fabrication of the semiconductor device 110 is mainly performed on the flat surface region 108. The width of the flat surface region 108 is preferably at least 5 µm, and more preferably is 10 µm or more. The flat surface region 108 has a high uniformity of thickness for each of the semiconductor layers 105, 107.

### Layer bending region

If the layer bending region 109 that includes the active layer 107a remains in the device 110, a portion of the emitted light from the active layer 107a is reabsorbed. As a result, it is preferable to remove at least a part of the active layer 107a in the layer bending region 109 by etching.

From another point of view, an epitaxial layer of the flat surface region 108 except for the opening area 103 has a lesser defect density than an epitaxial layer of the opening area 103. Therefore, it is more preferable that the aperture structures should be formed in the flat surface region 108 including on a wing region of the III-nitride ELO layers 105.

### Semiconductor device

The semiconductor device 110 is, for example, a Schottky diode, a light-emitting diode, a semiconductor laser, a photodiode, a transistor, etc., but is not limited to these devices. This invention is particularly useful for micro-LEDs and VCSELs. This invention is especially useful for a semiconductor laser which require smooth regions for cavity formation.

### Alternative Embodiments

The following describes alternative embodiments of the present invention.

### First Embodiment

The first embodiment is directed to a III-nitride-based light emitting diode device 110 with an attached pattern for extraction and/or guiding light, and a method for manufacturing the same.

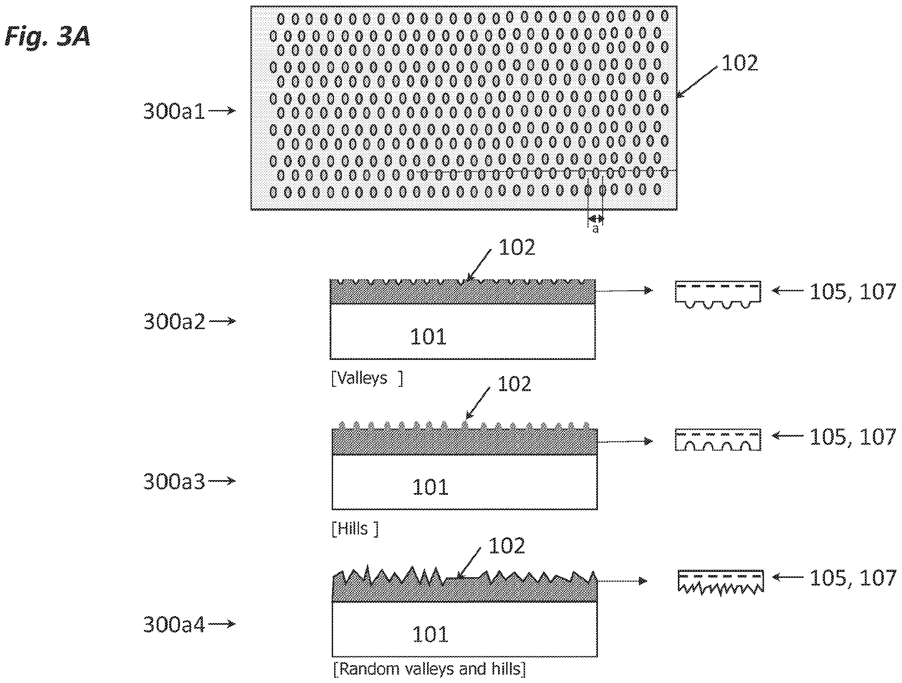

As shown in schematics 300a1, 300a2, 300a3, 300a4 in Fig. 3A, the growth restrict mask 102 is patterned to have random valleys and hills 300a4, for better light extraction are fabricated on the growth restrict mask 102. Alternatively, the same structures may also be fabricated on the host substrate 101, and then growth restrict mask 102 is laid over the fabricated structures on the host substrate 101. In either case, the growth restrict mask 102 takes on the shape of the structures, and subsequently, the III-nitride layers 105, 107 take on the inverse shape of the structures.

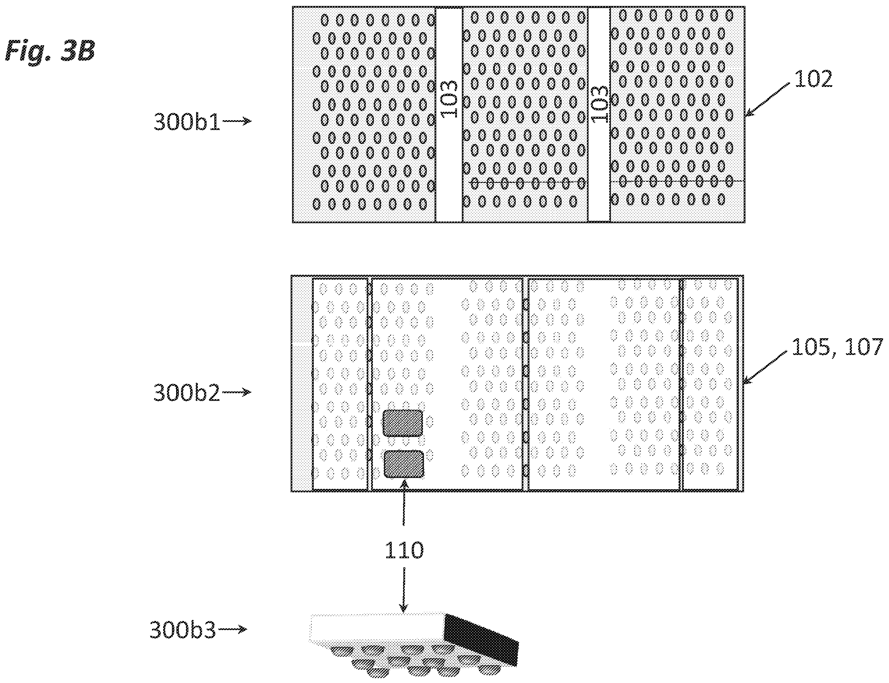

As shown in schematic 300b1, 300b2, 300b3 in Fig. 3B, the growth restrict mask 102 includes a plurality of striped open areas 103. The III-nitride ELO layers 105 grow from the substrate 101 through the open areas 103 and over the surface of the growth restrict mask 102, and take the shape of the pattern on the surface of the growth restrict mask 102. Device layers 107 are grown on the III-nitride ELO layers 105, and devices are fabricated on the wing regions of the III-nitride ELO layers 105.

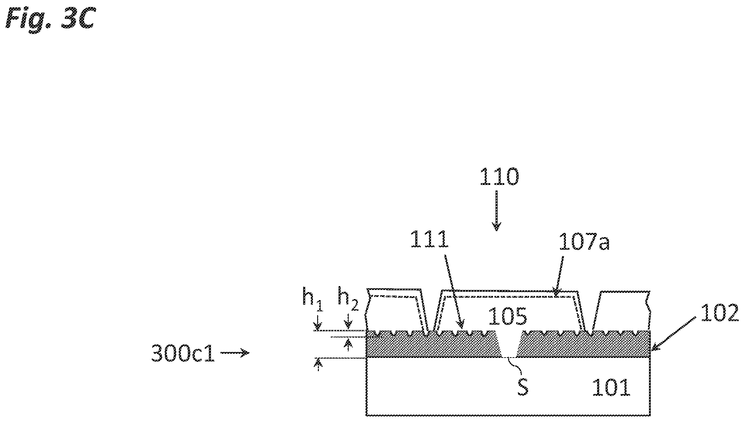

A cross section of the device 110 with the formulated pattern at the interface 111 between the growth restrict mask 102 and the III-nitride ELO layers 105 is shown in schematic 300c1 in Fig. 3C, where the pattern's depth on the growth restrict mask 102 is represented as h₂ and the height of the growth restrict mask 102 from the surface S of the host substrate 101 is represented as h₁. Preferably, the depth h₂ is smaller than h₁.

Preferably, the surface to start the ELO growth and the upper surface of the growth restrict mask 102 should be within 3 µm. Otherwise, if the application demands deeper patterns, such that h₂ is above 3 µm, one may follow an approach described in the third embodiment where a trench pattern is formed on the host substrate 101 to keep the surface of the host substrate 101 to the surface of the growth restrict mask 102 below 3 µm.

For a proof of concept, a feasibility experiment was conducted to transfer a random valley-hill pattern on to the interface 111 of the III-nitride ELO layer 105; however, several other patterns, such as PhCs, or a curved concave mirror (described in the second embodiment), are also possible.

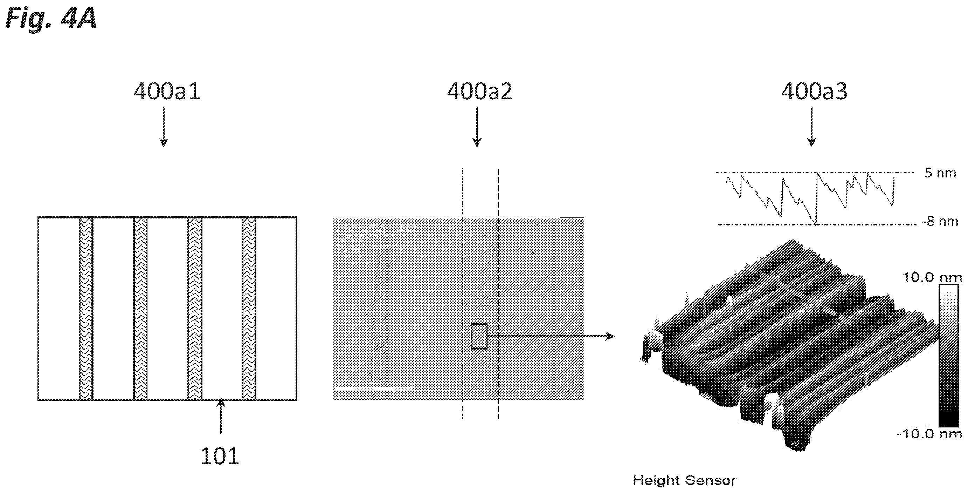

A non-polar GaN substrate 101 was used for this study. A random valley-hill pattern in the form of stripes was placed on the host substrate 101, as shown in schematic 400a1 and SEM image 400a2 in Fig. 4A. Atomic force microscope (AFM) image 400a3 in Fig. 4A shows the pattern on the stripes. The line-scan of the pattern is also shown in 400a3, where the range of hills and valleys is also provided.

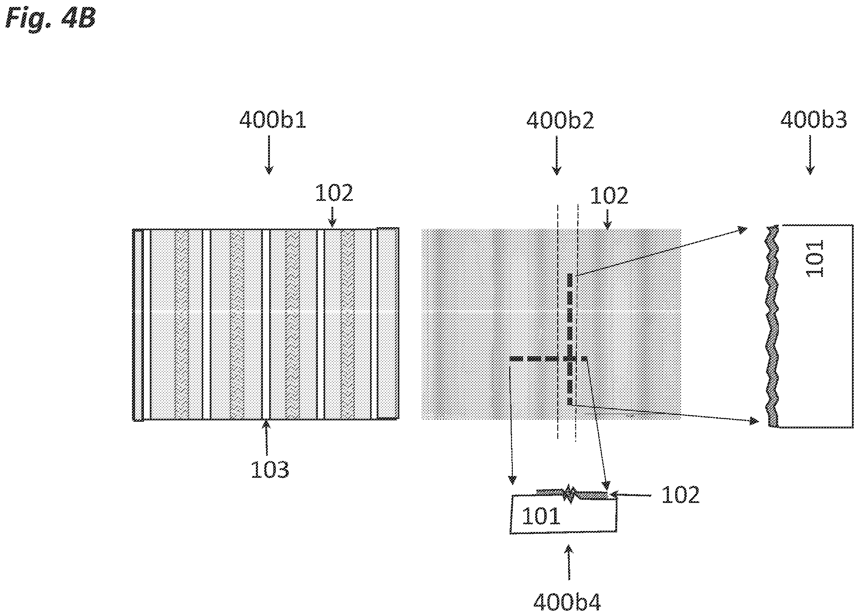

In the next step, a combination of growth restricts masks 102 comprised of 300 nm of SiO₂ was placed on the patterned host substrate 101 and opened parallel stripes on host substrate 101 along a c-axis, which serve as open areas 103, as shown in schematic 400b1, SEM image 400b2, schematic 400b3 and schematic 400b4 in Fig. 4B. A cross section of the host substrate 101 and the random valley hill pattern is schematically shown in 400b3 and 400b4.

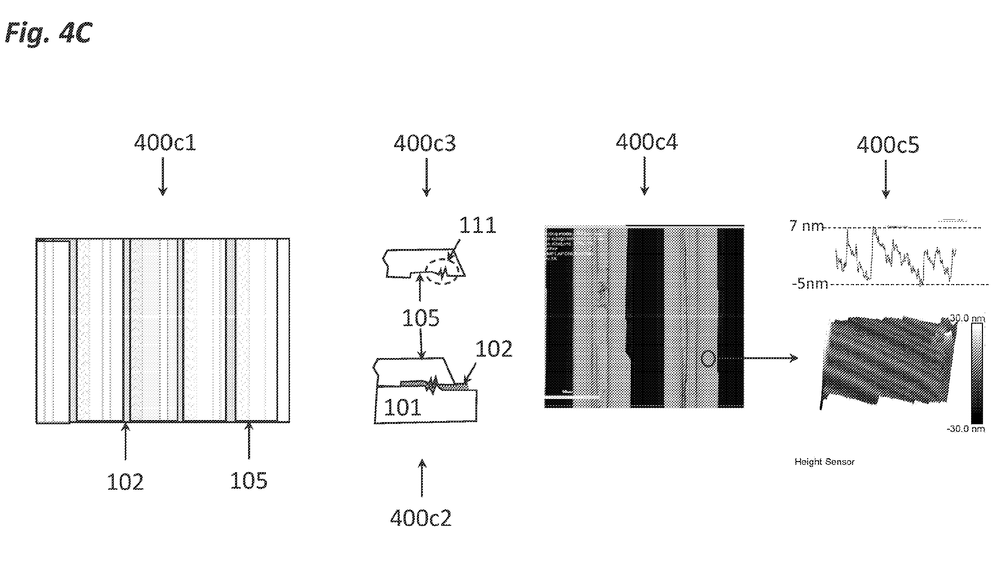

As shown in schematics 400c1, 400c2, 400c3, SEM image 400c4, and AFM image 400c5 in Fig. 4C, a III-nitride ELO layer 105 is grown using MOCVD and allowed to spread on the random valley pattern, as shown in schematic 400c1. Schematics 400c2 and 400c3 are cross section illustrations of the III-nitride ELO layer 105 over the growth restrict mask 102, and show the pattern transferred onto the interface 111 of the III-nitride ELO layer 105. SEM image 400c4 shows experimental results of the interface 111 of the III-nitride ELO layers 105, which is transferred onto an adhesive film. AFM scans were conducted at the position where a random valley hill pattern was predicted to be appear and the results are shown in 400c5. The pattern on the interface 111 of the III-nitride ELO layers 105 mostly copied the pattern on the growth restrict mask 102, as seen in 400a3 and 400c5.

Note that, for the sake of demonstration, the random valley hill pattern was limited to stripes; however, the same results can be observed even when the pattern is extended to the whole device 110.

The same is true when the pattern design is a PhC, wherein the PhC is implemented on the backside interface 111 of the III-nitride ELO layers 105 with the emitted light from the device 110 controlled to desired angles.

Then, the devices 110 with the patterned III-nitride ELO layers 105 are transferred onto a desired carrier, which can be a display panel, using tools such as a PDMS elastomer stamp, vacuum chuck, etc. The display panels can be used in a number of applications, such as TVs, laptops, phones, AR/VR/MR headsets, HUDs, etc.

### Second Embodiment

The second embodiment, not in accordance with the present invention, is about increasing the pattern size to realize a simple fabrication method for curved mirror VCSELs. Plano concave mirror VCSELs seem to be attractive for long cavity resonant cavity VCSELs, in terms of controlling resonances of the cavity wavelength and for thermal management. Researchers have proposed methods such as thinning the host substrate to the desired cavity length, forming a curved mirror on the back of the substrate, and photochemical etching for realizing thin cavity VCSELs, etc. However, these approaches have severe disadvantages in terms of controllability and substrate orientation limitations. The proposed method in this application works irrespective of substrate orientation or crystallinity, and moreover recycling of the host substrate is also possible.

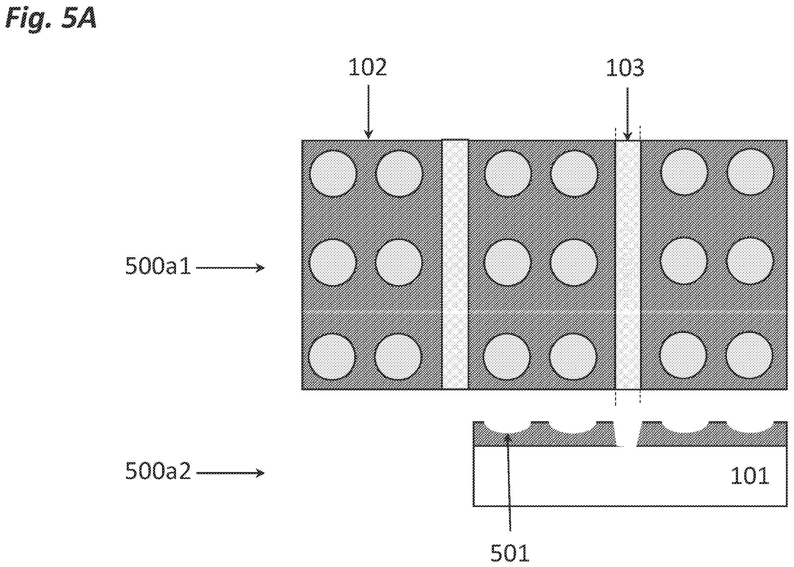

As shown in schematics 500a1 (top view), 500a2 (side view) in Fig. 5A, a growth restrict mask 102 with concave shaping 501 is formed on the host substrate 101 by leaving open areas 103 open on the host substrate 101.

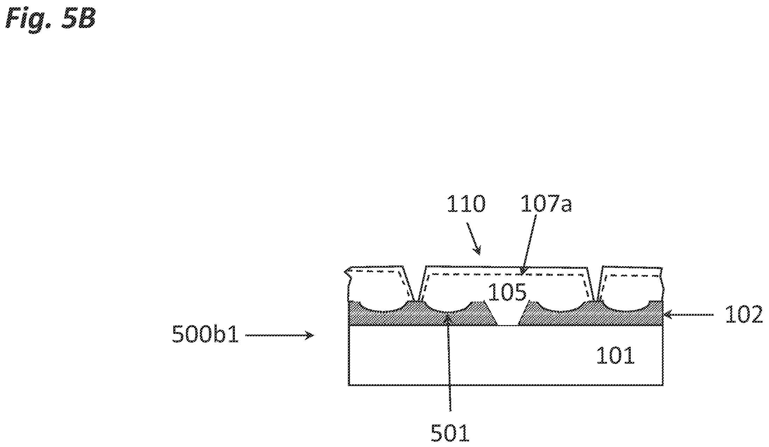

As shown in schematic 500b1 (side view) in Fig. 5B, the III-nitride ELO layers and device layers 107, including active region 107a, are formed on the growth restrict mask 102 with concave shaping 501 is formed on the host substrate 101 by leaving open areas 103 open on the host substrate 101.

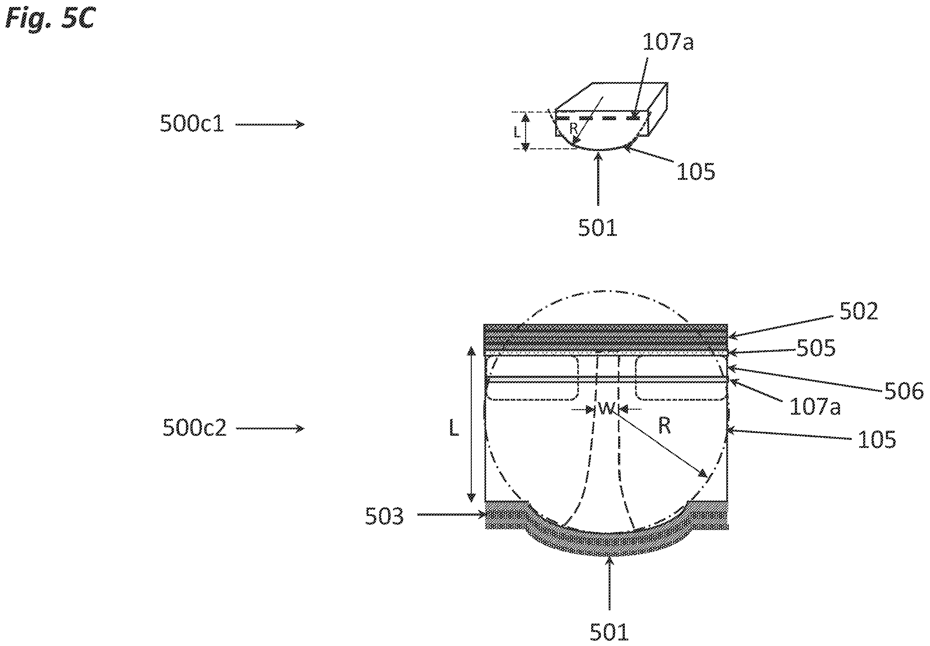

As shown in schematics 500c1 and 500c2 in Fig. 5C, the cavity length L is defined by the III-nitride ELO layers 105. As this is controlled epitaxially, precise control over the cavity length L can be achieved. The radius of curvature R of the curved shape 501 is designed such that a stable resonator's beam waist w is formed by DBRs comprising a plane mirror 502 and curved mirror 503, without generating diffraction or scattering losses. The beam waist w formed on the plane mirror 502 is dependent on the cavity length L and the radius of curvature R. Theoretically, by setting R equivalent to L, the beam waist w can be reduced to a minimum, thereby reducing diffraction loss. In one example, when a cavity length L greater than 20 µm is desired, active layers 107a can be placed 100 nm behind the plane mirror 502, as well as a tunnel junction or transparent conductive layer 505, and a current blocking region 506, thereby providing good lateral confinement.

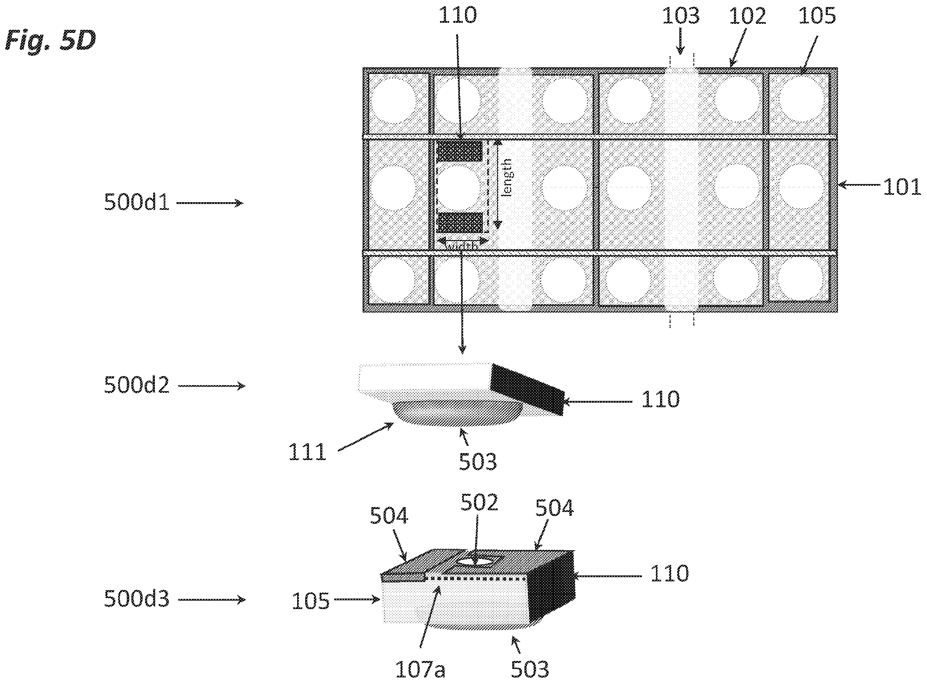

As shown in schematics 500d1 (top view), 500d2 (plan view), 500d3 (side view) in Fig. 5D, a VCSEL device 110 shown as a dashed rectangle is formed on the wing of the III-nitride ELO layers 105. Fabrication of the whole VCSEL device 110, including the DBR plane mirror 502, p-pads and n-pads 504, can be performed while the III-nitride ELO layers 105 are still attached to the host substrate 101. When the VCSEL device 110 is separated from the host substrate 101, the second DBR curved mirror 503 is made on the curved shape 501 at the bottom interface 111 of the III-nitride ELO layers 105, substantially not including the host substrate 101, to complete the VCSEL device 110.

### Third Embodiment

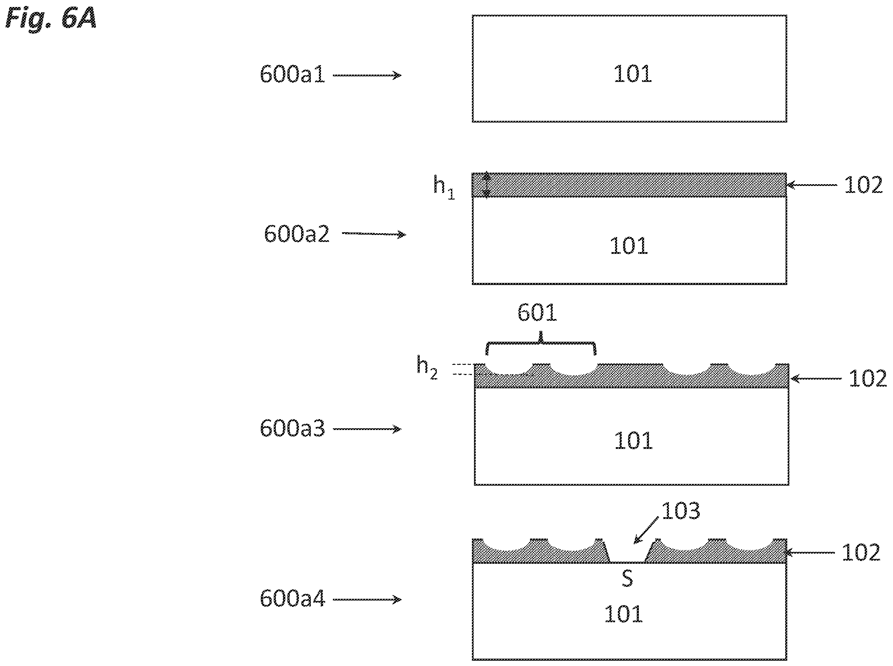

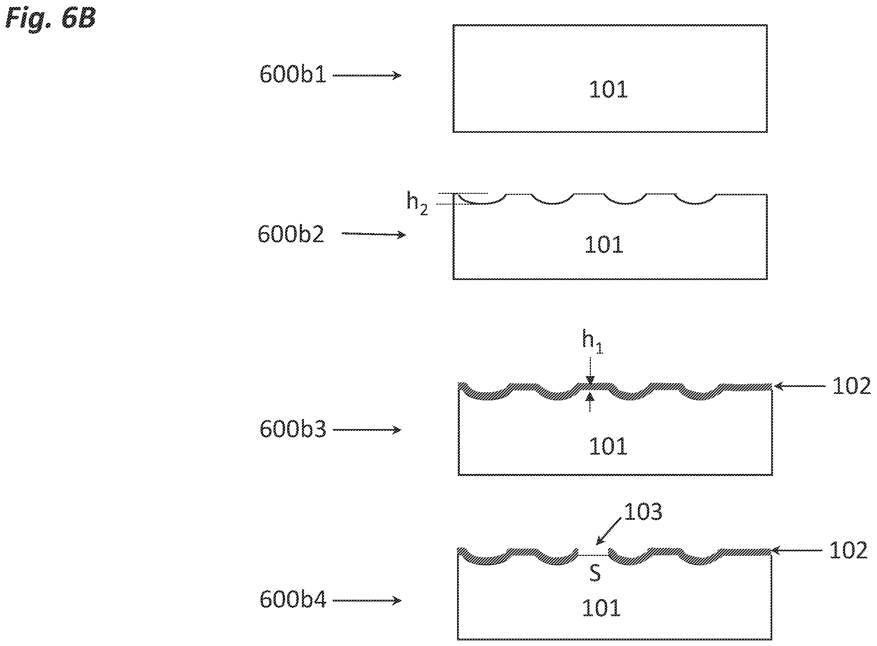

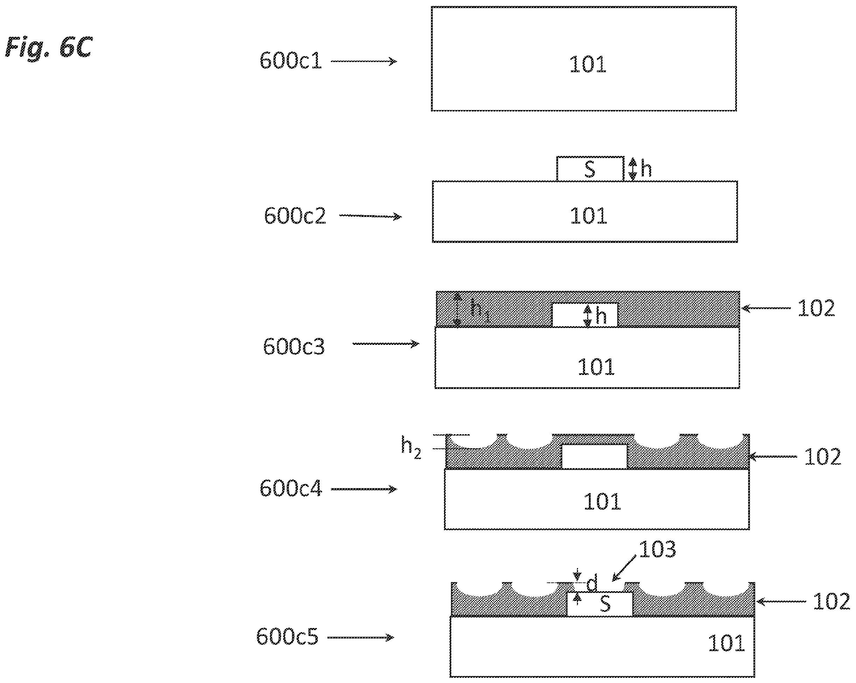

The third embodiment is about types of preparations to achieve patterns at the interface 111 of the III-nitride ELO layers 105, as indicated in Figs. 6A, 6B and 6C.

### Type 1 Pattern

As shown in schematics 600a1, 600a2, 600a3, 600a4 in Fig. 6A, Type 1 patterns are formed on the growth restrict mask 102. To achieve this, a III-nitride host substrate 101 is provided, as shown in schematic 600a1. A growth restrict mask 102 of thickness h₁ is laid on the III-nitride host substrate 101, as shown in schematic 600a2, and patterns 601 of desired parameters, for example, depth h₂, are formed on the growth restrict mask 102, as shown in schematic 600a3, using a nano-imprint lithography, or a similar pattern transfer technique, such as holographic lithography, photo lithography, etc. The open area 103 is opened, as shown in schematic 600a4, such that the surface S of the host substrate 101 is visible. The device 110 is grown on or above the host substrate 101 and the growth restrict mask 102. The III-nitride ELO layers 105 grown from the open area 103 bend along its edges at the growth restrict mask 102 and flow on to the designed pattern. Note that h₁ must be greater than h₂ in order to avoid substantial host substrate 101 material in the final device 110.

### Type 2 Pattern

As shown in schematics 600b1, 600b2, 600b3, 600b4 in Fig. 6B, an alternative embodiment may avoid a condition of h₁ > h₂ by creating the desired Type 2 pattern directly on the host substrate 101. A nano-imprint lithography, or similar method, with a combination of etching, is used to transfer a pattern to the host substrate 101. To achieve this, a III-nitride host substrate 101 is provided, as shown in schematic 600b1, and the host substrate 101 is patterned, as shown in schematic 600b2. The growth restrict mask 102 is placed over the patterned host substrate 101, as shown in schematic 600b3. The growth restrict mask 102 takes the shape of the patterns on the host substrate 101, like the one described in the proof of concept study. Later, open areas 103 on the host substrate 101, as shown in schematic 600b4, are used to perform the ELO. The III-nitride ELO layers 105 take the shape of patterns on the substrate 101 at the interface 111 resulting in a device 110 with an interface 111 pattern.

### Type 3 Pattern

Another alternative embodiment is shown in schematics 600c1, 600c2, 600c3, 600c4, 600c5 in Fig. 6C.

In some cases of Type 1, when h₂ demands more depth (> 3 µm), then the resulting h₁ will also increase to meet the condition that h₁ must be greater than h₂. As a result, the III-nitride ELO layers 105 originating at the open area 103 of the host substrate 101 may find it difficult to rise over the designed pattern shapes on the growth restrict mask 102. In such a scenario, the rising surface S near to the surface of growth restrict mask 102 would be preferred.

One such possibility is presented in Type 3. To achieve this, a III-nitride host substrate 101 is provided, as shown in schematic 600c1. A trench of height h is formed on the host substrate 101 at the open region 112, as shown in schematic 600c2. The growth restrict mask 102 of thickness h₁ is laid over the substrate 101 to cover the trench at the open region 103 and the host substrate 101, as shown in schematic 600c3. The desired pattern is formed on the growth restrict mask 102, for example, with depth h₂, as shown in schematic 600c4. The open area 103 is opened on the trench of the host substrate 101 so that surface S is just below a thickness d, as shown in schematic 600c5, thus providing a wall of lesser height for the later-grown III-nitride ELO layers 105.

### Fourth Embodiment

In a fourth embodiment, AlGaN layers are used as the island-like III-nitride semiconductor layers 105, 107. The AlGaN layers may be grown as the ELO III-nitride layers 105 on various off-angle substrates 101, as well as the device layers 107. The AlGaN layers 105, 107 can have a very smooth surface using the present invention. Using the present invention, the AlGaN layers 105, 107can be removed, as the island-like III-nitride semiconductor layers 105, 107, from various off-angle substrates 101.

In this case, an active laser, which emits UV-light (UV-A or UV-B or UV-C), can be grown on the AlGaN ELO layers 105. After removal, the AlGaN ELO layers 105 with an active region 107a looks like a UV-device with a pseudo-AlGaN substrate. By doing this, one can obtain a high-quality UV-LED device 110, which is useful in applications of sterilization, lighting, etc.

### Fifth Embodiment

In a fifth embodiment, the III-nitride ELO layers 105 are grown on various off-angle substrates 101. The off-angle orientations range from 0 to +15 degrees and 0 to -28 degrees from the m-plane towards the c-plane. The present invention can remove the bar of the device 110 from the various off-angle substrates 101. This is a big advantage for this technique, as various off-angle orientations semiconductor plane devices 110 can be realized without changing the fabrication process.

### Sixth Embodiment

In a sixth embodiment, the III-nitride ELO layers 105 are grown on c-plane substrates 101 with two different mis-cut orientations. The III-nitride semiconductor layers 105, 107 are removed after processing a desired device 110 using the invention described in this application.

### Seventh Embodiment

In a seventh embodiment, a sapphire substrate 101 is used as the hetero-substrate 101. The resulting structure is almost the same as the first and second embodiments, except for using the sapphire substrate 101 and a buffer layer. In this embodiment, the buffer layer may also include an additional n-GaN layer or an undoped GaN layer. The buffer layer is grown at a low temperature of about 500 - 700 °C degrees. The n-GaN layer or undoped GaN layer is grown at a higher temperature of about 900 - 1200 °C degrees. The total thickness is about 1 - 3 µm. Then, the growth restrict mask 102 is disposed on the buffer layer and the n-GaN layer or undoped GaN layer.

On the other hand, it is not necessary to use the buffer layer. For example, the growth restrict mask 102 can be disposed on the hetero-substrate 101 directly. After that, the III-nitride ELO layers 105 and/or III-nitride-based semiconductor device layers 107 can be grown.

### Eighth Embodiment

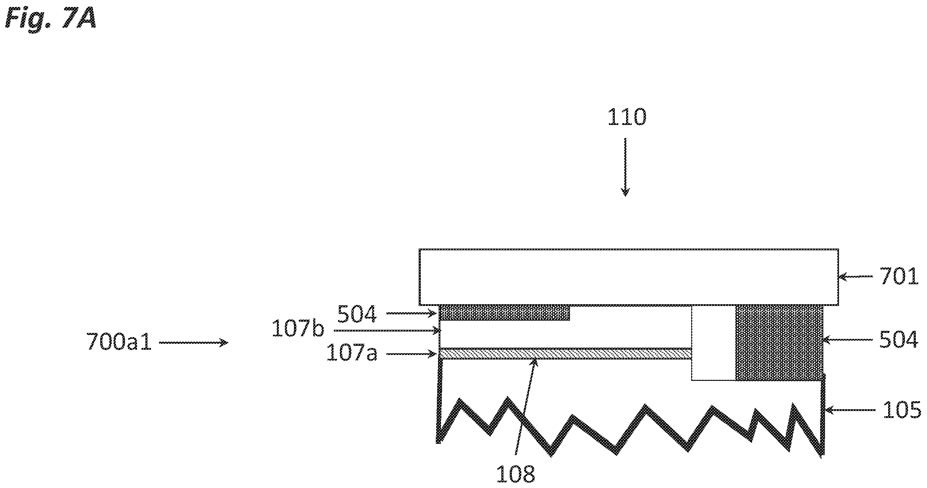

An eighth embodiment describes a device made using the first, second or third embodiments described above. A random valley-hill pattern LED device 110 is presented in schematic 700a1 in Fig. 7A. After patterning growth restrict mask 102 as a random valley-hill pattern, the III-nitride ELO layers 105 are grown from the open areas 103 imprinted with the random valley-hill pattern. Then, an LED device 110 is fabricated on the III-nitride ELO layers 105, including an active region 107a, as well as p-GaN 107b and n-GaN layers 105. Contact pads 504 in these devices 110 can be formed on the flat surface 108 on the opposite side of the random valley-hill pattern of the III-nitride ELO layers 105. The resulting device 110, once removed from the substrate 101, is attached to a sub-mount 701.

This approach of having a light extraction/controlling structure near the active region 107a will certainly improve light extraction efficiency. Conventionally, such light extraction and/or controlling structures were fabricated on either the backside of the substrate 101 or on the front surface of the device 110, where the former depends on substrate 101 conductivity, and the latter imposes restrictions on the current injection and complicates the fabrication. However, the method described in this invention still allows for fabrication on flat surface 108 of the light emitting device 110, while allowing light controlling structures to be placed near the active region 107a. Alternatively, different shapes, such as PhCs, can be used with this LED to provide the best light extraction. Schematics 300a2, 300a3 and 300a4 in Fig. 3A show different examples of the shapes that can be used for the better light extraction/control.

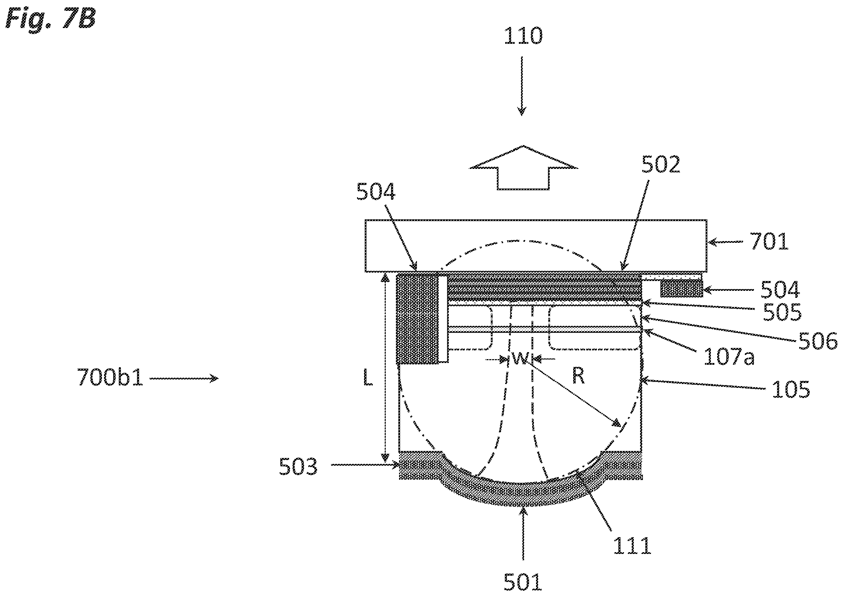

In a similar way, a plano-concave mirror resonant cavity VCSEL device 110 can be fabricated, as shown in schematic 700a2 in Fig. 7B, by modifying the pattern on the growth restrict mask 102 as a concave shape 501. The cavity length L is precisely controlled epitaxially and the radius of curvature R of the structure is derived from concave shape 501. Proper parameters for L and R are designed so that the beam waist w forms on the plane mirror 502. In addition to top and bottom DBR mirrors 502, 503, the resonant cavity comprises an active region 107a, a tunnel junction or transparent conductive layer 505, a current blocking region 506, and p-type layers 107b (not shown). Contact pads 504 are defined and singularization is performed, following which a transparent sub-mount 701 is attached on the plane mirror 502. Finally, a bottom side DBR curved mirror 503 is attached to the epitaxially formed curved shape 501 of the III-nitride ELO layers 105 at the backside interface 111.

### Conclusion

The foregoing description of one or more embodiments has been presented for the purposes of illustration and description. It is not intended to be exhaustive or to limit the invention to the precise form disclosed. It is intended that the scope of the invention be limited not by this detailed description, but rather by the claims appended hereto.

## Claims

1. A method of providing one or more light-emitting devices, comprising:
preparing a host substrate;
depositing a growth restrict mask on the host substrate, wherein one or more patterns are formed in the growth restrict mask on the host substrate, and the growth restrict mask includes opening areas that expose the host substrate;
growing one or more epitaxial lateral overgrowth, ELO, layers on the host substrate from the opening areas in the growth restrict mask, and then laterally over the growth restrict mask and the patterns formed in the growth restrict mask, wherein patterns comprise one or more random valley-hill patterns that are transferred onto the ELO layers, resulting in light controlling structures in the ELO layers; and
forming one or more device layers that emit light on the ELO layers.

2. The method of claim 1, wherein the patterns are formed on the host substrate.

3. The method of claim 2, wherein the one or more patterns are transferred onto the growth restrict mask.

4. The method of claim 1, wherein the device layers include copies of the patterns.

5. The method of claim 1, wherein the patterns result in light controlling structures at an interface between the ELO layers and the growth restrict mask.

6. The method of claim 1, wherein the patterns comprise one or more unleveled regions.

7. The method of claim 1, wherein the host substrate has trenches.

8. The method of claim 1, wherein the method is independent of crystal orientations of the host substrate.

9. The method of claim 1, wherein the growth restrict mask is comprised of one or more layers.

10. A light-emitting device, comprising:
a host substrate;
a growth restrict mask on the host substrate, wherein one or more patterns are formed in the growth restrict mask on the host substrate, and the growth restrict mask includes opening areas that expose the host substrate;
one or more epitaxial layers on the host substrate in the opening areas in the growth restrict mask, and extending laterally over the growth restrict mask and the patterns formed in the growth restrict mask, wherein the patterns comprise one or more random valley-hill patterns that are transferred onto the laterally extending epitaxial layers, resulting in light controlling structures in the laterally extending epitaxial layers; and
one or more device layers that emit light formed on the laterally extending epitaxial layers

11. The device of claim 10, wherein the device is a light emitting diode or a vertical cavity surface emitting laser.

12. The device of claim 10, wherein the patterns are formed on the host substrate and transferred onto the growth restrict mask.

13. The device of claim 10, wherein device layers include copies of the patterns.

14. The device of claim 10, wherein the patterns result in light controlling structures at an interface between the lateral extending epitaxial layers and the growth restrict mask.

15. The device of claim 10, wherein the patterns comprise one or more unleveled regions.

## Patentansprüche

1. Ein Verfahren zum Bereitstellen einer oder mehrerer lichtemittierender Vorrichtungen, das Folgendes beinhaltet:
Vorbereiten eines Wirtssubstrats;
Abscheiden einer Wachstumsbegrenzungsmaske auf dem Wirtssubstrat, wobei ein oder mehrere Muster in der Wachstumsbegrenzungsmaske auf dem Wirtssubstrat gebildet werden und die Wachstumsbegrenzungsmaske Öffnungsbereiche umfasst, die das Wirtssubstrat freilegen;
Züchten einer oder mehrerer epitaxialer lateraler Überwachsungs-Schichten, ELO-Schichten, auf dem Wirtssubstrat von den Öffnungsbereichen in der Wachstumsbegrenzungsmaske und dann lateral über der Wachstumsbegrenzungsmaske und den in der Wachstumsbegrenzungsmaske gebildeten Mustern, wobei Muster ein oder mehrere zufällige Tal-Hügel-Muster beinhalten, die auf die ELO-Schichten übertragen werden, was zu lichtsteuernden Strukturen in den ELO-Schichten führt; und
Bilden einer oder mehrerer Vorrichtungsschichten, die Licht emittieren, auf den ELO-Schichten.

2. Verfahren gemäß Anspruch 1, wobei die Muster auf dem Wirtssubstrat gebildet werden.

3. Verfahren gemäß Anspruch 2, wobei das eine oder die mehreren Muster auf die Wachstumsbegrenzungsmaske übertragen werden.

4. Verfahren gemäß Anspruch 1, wobei die Vorrichtungsschichten Kopien der Muster umfassen.

5. Verfahren gemäß Anspruch 1, wobei die Muster zu lichtsteuernden Strukturen an einer Grenzfläche zwischen den ELO-Schichten und der Wachstumsbegrenzungsmaske führen.

6. Verfahren gemäß Anspruch 1, wobei die Muster einen oder mehrere nicht nivellierte Regionen beinhalten.

7. Verfahren gemäß Anspruch 1, wobei das Wirtssubstrat Gräben aufweist.

8. Verfahren gemäß Anspruch 1, wobei das Verfahren unabhängig von Kristallorientierungen des Wirtssubstrats ist.

9. Verfahren gemäß Anspruch 1, wobei die Wachstumsbegrenzungsmaske aus einer oder mehreren Schichten besteht.

10. Eine lichtemittierende Vorrichtung, die Folgendes beinhaltet:
ein Wirtssubstrat;
eine Wachstumsbegrenzungsmaske auf dem Wirtssubstrat, wobei ein oder mehrere Muster in der Wachstumsbegrenzungsmaske auf dem Wirtssubstrat gebildet werden und die Wachstumsbegrenzungsmaske Öffnungsbereiche umfasst, die das Wirtssubstrat freilegen;
eine oder mehrere epitaxiale Schichten auf dem Wirtssubstrat in den Öffnungsbereichen in der Wachstumsbegrenzungsmaske und sich lateral über die Wachstumsbegrenzungsmaske und die in der Wachstumsbegrenzungsmaske gebildeten Muster erstreckend, wobei die Muster ein oder mehrere zufällige Tal-Hügel-Muster beinhalten, die auf die sich lateral erstreckenden epitaxialen Schichten übertragen werden, was zu lichtsteuernden Strukturen in den sich lateral erstreckenden epitaxialen Schichten führt; und
eine oder mehrere Vorrichtungsschichten, die Licht emittieren, die auf den sich lateral erstreckenden epitaxialen Schichten gebildet sind.

11. Vorrichtung gemäß Anspruch 10, wobei die Vorrichtung eine lichtemittierende Diode oder ein oberflächenemittierender Laser mit vertikalem Resonator ist.

12. Vorrichtung gemäß Anspruch 10, wobei die Muster auf dem Wirtssubstrat gebildet und auf die Wachstumsbegrenzungsmaske übertragen werden.

13. Vorrichtung gemäß Anspruch 10, wobei die Vorrichtungsschichten Kopien der Muster umfassen.

14. Vorrichtung gemäß Anspruch 10, wobei die Muster zu lichtsteuernden Strukturen an einer Grenzfläche zwischen den sich lateral erstreckenden epitaxialen Schichten und der Wachstumsbegrenzungsmaske führen.

15. Vorrichtung gemäß Anspruch 10, wobei die Muster eine oder mehrere nicht nivellierte Regionen beinhalten.

## Revendications

1. Un procédé de fourniture d'un ou de plusieurs dispositifs émettant de la lumière, comprenant :
préparer un substrat hôte ;
déposer un masque de restriction de croissance sur le substrat hôte, où un ou plusieurs motifs sont formés dans le masque de restriction de croissance sur le substrat hôte, et le masque de restriction de croissance inclut des zones d'ouverture qui exposent le substrat hôte ;
faire croître une ou plusieurs couches de surcroissance latérale épitaxiale, ELO, sur le substrat hôte à partir des zones d'ouverture dans le masque de restriction de croissance, et ensuite latéralement par-dessus le masque de restriction de croissance et les motifs formés dans le masque de restriction de croissance, où les motifs comprennent un ou plusieurs motifs vallée-colline aléatoires qui sont transférés sur les couches ELO, résultant en des structures de contrôle de lumière dans les couches ELO ; et
former une ou plusieurs couches de dispositif qui émettent de la lumière sur les couches ELO.

2. Le procédé de la revendication 1, où les motifs sont formés sur le substrat hôte.

3. Le procédé de la revendication 2, où les un ou plusieurs motifs sont transférés sur le masque de restriction de croissance.

4. Le procédé de la revendication 1, où les couches de dispositif incluent des copies des motifs.

5. Le procédé de la revendication 1, où les motifs résultent en des structures de contrôle de lumière au niveau d'une interface entre les couches ELO et le masque de restriction de croissance.

6. Le procédé de la revendication 1, où les motifs comprennent une ou plusieurs régions non nivelées.

7. Le procédé de la revendication 1, où le substrat hôte a des tranchées.

8. Le procédé de la revendication 1, où le procédé est indépendant des orientations cristallines du substrat hôte.

9. Le procédé de la revendication 1, où le masque de restriction de croissance est composé d'une ou de plusieurs couches.

10. Un dispositif émettant de la lumière, comprenant :
un substrat hôte ;
un masque de restriction de croissance sur le substrat hôte, où un ou plusieurs motifs sont formés dans le masque de restriction de croissance sur le substrat hôte, et le masque de restriction de croissance inclut des zones d'ouverture qui exposent le substrat hôte ;
une ou plusieurs couches épitaxiales sur le substrat hôte dans les zones d'ouverture dans le masque de restriction de croissance, et s'étendant latéralement par-dessus le masque de restriction de croissance et les motifs formés dans le masque de restriction de croissance, où les motifs comprennent un ou plusieurs motifs vallée-colline aléatoires qui sont transférés sur les couches épitaxiales s'étendant latéralement, résultant en des structures de contrôle de lumière dans les couches épitaxiales s'étendant latéralement ; et
une ou plusieurs couches de dispositif qui émettent de la lumière, formées sur les couches épitaxiales s'étendant latéralement.

11. Le dispositif de la revendication 10, où le dispositif est une diode émettant de la lumière ou un laser à cavité verticale émettant par la surface.

12. Le dispositif de la revendication 10, où les motifs sont formés sur le substrat hôte et transférés sur le masque de restriction de croissance.

13. Le dispositif de la revendication 10, où les couches de dispositif incluent des copies des motifs.

14. Le dispositif de la revendication 10, où les motifs résultent en des structures de contrôle de lumière au niveau d'une interface entre les couches épitaxiales s'étendant latéralement et le masque de restriction de croissance.

15. Le dispositif de la revendication 10, où les motifs comprennent une ou plusieurs régions non nivelées.
